# EUROPEAN PATENT APPLICATION

(11) **EP 4 095 946 A1**
(43) Date of publication of application: **30.11.2022**
(21) Application number: 20937234.1
(22) Date of filing: 30.12.2020
(51) Int. Cl.: H01M 4/36, H01M 4/505, H01M 4/525, H01M 4/62, H01M 10/0525

(54) **COMPOSITE COBALT-FREE POSITIVE ELECTRODE MATERIAL AND PREPARATION METHOD THEREFOR**

(30) Priority: 25.05.2020 CN 202010452133
(71) Applicant: SVOLT ENERGY TECHNOLOGY CO., LTD, Changzhou, Jiangsu 213200 (CN)
(72) Inventor: SUN, Mingzhu, hangzhou, Jiangsu 213200 (CN); YANG, Hongxin, hangzhou, Jiangsu 213200 (CN); JIANG, Weijun, hangzhou, Jiangsu 213200 (CN); QIAO, Qiqi, hangzhou, Jiangsu 213200 (CN); XU, Xinpei, hangzhou, Jiangsu 213200 (CN); MA, Jiali, hangzhou, Jiangsu 213200 (CN); SHI, Zetao, hangzhou, Jiangsu 213200 (CN); CHEN, Sixian, hangzhou, Jiangsu 213200 (CN); WANG, Pengfei, hangzhou, Jiangsu 213200 (CN)
(74) Representative: De Bonis, Paolo
(86) International application number: PCT/CN2020/141191
(87) International publication number: WO 2021/238202

(57) **Abstract**

Provided is a composite cobalt-free positive electrode material, belonging to the technical field of lithium batteries. The material includes a cobalt-free positive electrode material and a composite coating layer. The composite coating layer is formed by uniformly coating the surface of the cobalt-free positive electrode material with a coating material and a dispersant. A metal oxide is used as the coating material, and the surface stability of the positive electrode material is effectively improved.

## Description

### Technical Field

The present disclosure relates to the field of lithium batteries, for example, to a composite cobalt-free cathode material and a preparation method thereof.

### Background

With the gradual development and popularization of new energy vehicles, people are paying more attention to the related resources of lithium-ion batteries. Among them, nickel-manganese layered materials have become a research hotspot in recent years due to their advantages of high energy density, low cost, and long cycle life, etc. Studies have found that the particle strength and cycle time of single crystal materials are higher than those of polycrystal materials, but there are major problems during processing, resulting in poor coating effect, shedding of the surface layer, and ultimately damage to the interface, so that the side reactions with the electrolyte increase, and the gas production leads to cycle deterioration, which limits practical applications.

Cathode material is a small single crystal material. Due to its small particle size, gas is generated during the high-temperature cycle, and again because it is a single crystal material and is a cobalt-free cathode material, the DCR is too large and the rate performance is poor. Therefore, there are limitations in the choice of coating materials. When a coating material with poor fluidity is co-coated with a small single crystal material, the material cannot flow normally and sticks to the inner wall of the equipment, resulting in uneven coating, in severe cases, it can't even be coated normally.

### Summary

The present disclosure provides a composite cobalt-free cathode material and a preparation method thereof.

In one embodiment of the present disclosure, a composite cobalt-free cathode material is provided, which includes a cobalt-free cathode material and a composite coating layer, wherein the composite coating layer is formed by uniformly wrapping the surface of the cobalt-free cathode material with a coating material and a dispersant.

In one embodiment provided by the present disclosure, by adding a substance that does not affect the coating performance of the material and a substance with the coating function for co-coating, the coating effect of the material is improved and the gas production in the cycle process is reduced; by adding a dispersant material with good fluidity for co-coating, the rate and cycle performances of the cobalt-free single crystal cathode material are improved. The present disclosure adopts a unique composite coating design concept, which improves the uniformity of material coating and increases the rate performance of the product.

In one embodiment, the cobalt-free cathode material is a cobalt-free single crystal cathode material, and its chemical expression is LiNiₓMn_{y}O₂, 0.3≤x≤1.0, for example, 0.3, 0.4, 0.5, 0.6, 0.7, 0.8, 0.9 or 1.0, etc., x+y=1, D50 particle size is 1 to 5 µm, for example, 1.0 µm, 1.5 µm, 2.0 µm, 2.5 µm, 3.0 µm, 3.5 µm, 4.0 µm, 4.5 µm or 5.0 µm, etc.

In one embodiment provided by the present disclosure, the octahedral structure is stabilized by two strong chemical bonding elements of nickel and manganese, and the stability of the material is improved. Due to the single crystal material has stronger particle strength and better stable structure during the rolling process, the pressure resistance is significantly improved, and the service life of the cobalt-free cathode material is significantly extended.

In one embodiment, the coating material includes at least one of Al₂O₃, TiO₂, ZrO₂, MgO, B₂O₃ and WO₃, and the dispersant includes at least one of graphite, polyethylene, polyvinylpyrrolidone, polyvinyl alcohol, polyethylene glycol and phenolic resin.

In one embodiment provided by the present disclosure, a metal oxide is used as the coating material, and a nano-oxide layer is coated on the surface of the cobalt-free cathode single crystal material. In addition, since the single crystal material structure has the characteristic of a few grain boundaries inside the particles, it can reduce the side reaction when the cobalt-free cathode single crystal material is in contact with the electrolyte, improving the surface stability of the cobalt-free cathode material, and reducing the problem of gas production during the cycle of the battery, and effectively improving the cycle performance of the material under high pressure. The addition of the dispersant enhances the fluidity of the surface coating of the cobalt-free cathode material, so that the coating material can be more uniformly coated on the surface of the cobalt-free cathode material, forming a porous three-dimensional surface layer material on the surface of the cobalt-free cathode material, improving the coating effect.

In one embodiment, the mass percentage content of the coating material is 0.1% to 3% of the mass of the cobalt-free cathode material, for example, 0.1%, 0.5%, 1%, 1.5%, 2%, 2.5% or 3%, etc.; the ratio of the dispersant to the coating material is (1:1000) to (1:10), for example, 1:10, 1:100, 1:200, 1:300, 1:400, 1:500, 1:600, 1:700, 1:800, 1:900 or 1:1000, etc.

In one embodiment of the present disclosure, a method for preparing a composite cobalt-free cathode material as described in one embodiment is provided, and the preparation method includes:
(1) a cobalt-free single crystal cathode material is prepared;
(2) the cobalt-free single crystal cathode material, a coating material, and a dispersant are dry mixed to obtain a mixture; and
(3) the mixture is calcined at 200 to 800 °C for 4 to 10 hours to obtain a composite cobalt-free cathode material product, for example 200 °C, 250 °C, 300 °C, 350 °C, 400 °C, 450 °C, 500 °C, 550 °C, 600 °C, 650 °C, 700 °C, 750 °C or 800 °C, etc.; for example, calcined for 4 hours, 5 hours, 6 hours, 7 hours, 8 hours, 9 hours, or 10 hours, etc.

In one embodiment provided by the present disclosure, in order to improve the coating effect so that the coating material can be uniformly coated on the surface of the cathode material, metal oxide is used as the coating material to effectively improve the surface stability of the cathode material and reduce the problem of gas production during the cycle of the battery, thereby increasing the cycle life of the battery, at the same time improving the rate performance. Due to the poor fluidity of the material itself, a dispersant with better fluidity is added to the coating material in the present disclosure for co-coating, so that the coating material that is difficult to disperse can be more uniformly coated on the surface of the cathode material, and then undergoing calcination, metal oxide and fast ion conductor layer material with a porous three-dimensional structure is formed on the surface of the particles. In one embodiment, the preparation method specifically includes:
S1, a lithium source and a precursor NiₓMn₁₋ₓ(OH)₂ are weighed, and uniformly mixed;
S2, the mixed material is sintered, and the block material after the sintering reaction is crushed to obtain a cobalt-free single crystal cathode material;
S3, the cobalt-free single crystal cathode material, a coating material, and a dispersant are dry mixed in a mixer, a metal oxide is used as the coating material, the mass percentage content of which is 0.1% to 3% of the mass of the cobalt-free single crystal cathode material, for example, 0.1%, 0.5%, 1%, 1.5%, 2%, 2.5% or 3%, etc.; the ratio of the dispersant to the coating material is (1:1000) to (1:10), for example, 1:10, 1:100, 1:200, 1:300, 1:400, 1:500, 1:600, 1:700, 1:800, 1:900 or 1:1000, etc.;
S4, the coated cathode material is calcined at 200 to 800 °C for 4 to 10 hours, and the coating material and the dispersant are uniformly coated on the surface of the particles, for example 200 °C, 250 °C, 300 °C, 350 °C, 400 °C, 450 °C, 500 °C, 550 °C, 600 °C, 650 °C, 700 °C, 750 °C or 800 °C, etc.; for example, calcined for 4 hours, 5 hours, 6 hours, 7 hours, 8 hours, 9 hours, or 10 hours, etc.; and
S5, the calcined material is subjected to airflow classification and sieved to obtain the final product.

In one embodiment, in the step S1, the D50 particle size of the precursor is 1 to 4 µm, for example 1.0 µm, 1.5 µm, 2.0 µm, 2.5 µm, 3.0 µm, 3.5 µm, 4.0 µm, etc.; the lithium source and the precursor are weighed at a Li/(Ni+Mn) molar ratio of 0.95 to 1.10, for example 0.95, 0.96, 0.97, 0.98, 0.99, 1.0 or 1.1, etc.

In one embodiment, in the step S2, the temperature of the sintering reaction is 500 to 1000 °C, for example, 500 °C, 550 °C, 600 °C, 650 °C, 700 °C, 750 °C, 800 °C, 850 °C, 900 °C, 950 °C or 1000 °C, etc.; and the reaction is carried out under an air or oxygen condition for 10 to 25 hours, for example, 10 hours, 11 hours, 12 hours, 13 hours, 14 hours, 15 hours, 16 hours, 17 hours, 18 hours, 19 hours, 20 hours, 21 hours, 22 hours, 23 hours, 24 hours, or 25 hours, etc.

In one embodiment, in the step S2, mechanical mill or jet mill is used for crushing, and the obtained cobalt-free single crystal cathode material has a D50 particle size of 1 to 5 µm, for example, 1.0 µm, 1.5 µm, 2.0 µm, 2.5 µm, 3.0 µm, 3.5 µm, 4.0 µm, 4.5 µm or 5.0 µm, etc.

In one embodiment, in the step S5, the airflow classification frequency is 100 to 200 Hz, for example, 100 Hz, 110 Hz, 120 Hz, 130 Hz, 140 Hz, 150 Hz, 160 Hz, 170 Hz, 180 Hz, 190 Hz or 200 Hz, etc.; a sieve with a mesh size of 300 to 400 mesh is used for sieving, for example, 300 mesh, 310 mesh, 320 mesh, 330 mesh, 340 mesh, 350 mesh, 360 mesh, 370 mesh, 380 mesh, 390 mesh, or 400 mesh, etc.

### Brief Description of the Drawings

The accompanying drawings are used to provide a further understanding of the technical solution of the present disclosure, and constitute a part of the specification, which are used to explain the technical solution of the present disclosure together with the embodiments of the present application, and do not constitute a limitation to the technical solution of the present disclosure.
Figure 1 is a SEM image of a composite cobalt-free cathode material prepared in an example of the present disclosure;
Figure 2 is a SEM image of a composite cobalt-free cathode material prepared in a comparative example of the present disclosure;
Figure 3 is a comparison diagram of capacity test of batteries prepared by the composite cobalt-free cathode materials obtained in an example and a comparative example of the present disclosure;
Figure 4 is a comparison diagram of rate performance test of batteries prepared by the composite cobalt-free cathode materials obtained in an example and a comparative example of the present disclosure;
Figure 5 is a comparison diagram of cycle performance test of batteries prepared by the composite cobalt-free cathode materials obtained in an example and a comparative example of the present disclosure.

### Detailed Description

The technical solutions of the present disclosure will be further described below in conjunction with the drawings and specific embodiments.

In one embodiment, the present disclosure provides a composite cobalt-free cathode material, which includes a cobalt-free cathode material and a composite coating layer, wherein the composite coating layer is formed by uniformly wrapping the surface of the cobalt-free cathode material with a coating material and a dispersant.

The cobalt-free cathode material is a cobalt-free single crystal cathode material, the chemical expression is LiNiₓMn_{y}O₂, which satisfies 0.3≤x≤1.0, x+y=1, for example, LiNi_{0.65}Mn_{0.35}O₂, LiNi_{0.35}Mn_{0.65}O₂, LiNi_{0.5}Mn_{0.5}O₂, etc. When the above-mentioned cobalt-free single crystal cathode material is used, the octahedral structure is stabilized by two strong chemical bonding elements of nickel and manganese, and the stability of the material is improved. Since the single crystal material has stronger particle strength and better stable structure during the rolling process, the pressure resistance is significantly improved, and the service life of the cobalt-free cathode material is significantly extended.

The coating material can be any one selected from the group consisting of Al₂O₃, TiO₂, ZrO₂, MgO, B₂O₃, WO₃, and a combination of more selected therefrom, for example Al₂O₃, Al₂O₃+TiO₂, TiO₂+ZrO₂, Al₂O₃+MgO+ZrO₂, etc. The above-mentioned metal oxide is used as the coating material, and a nano-oxide layer is coated on the surface of the cobalt-free cathode single crystal material. In addition, due to the single crystal material structure has the characteristic of a few grain boundaries inside the particles, it can reduce the side reaction when the cobalt-free cathode single crystal material is in contact with the electrolyte, improving the surface stability of the cobalt-free cathode material, and reducing the problem of gas production during the cycle of the battery, and effectively improving the cycle performance of the material under high pressure.

The dispersant can be any one selected from the group consisting of graphite, polyethylene, polyvinylpyrrolidone, polyvinyl alcohol, polyethylene glycol, phenolic resin, and a combination of more selected therefrom, for example, graphite, polyvinyl + polyvinyl alcohol, polyvinyl alcohol + polyethylene glycol, etc. The dispersant enhances the fluidity of the surface coating of the cobalt-free cathode material, so that the coating material can be more uniformly coated on the surface of the cobalt-free cathode material, forming a porous three-dimensional surface layer material on the surface of the cobalt-free cathode material, thus improving the coating effect.

### Example 1

A composite cobalt-free cathode material provided in this Example is obtained by the following preparation method:
S1. lithium hydroxide and a precursor Ni_{0.65}Mn_{0.35}(OH)₂ with a D50 particle size of 3 µm were weighed at a Li/(Ni+Mn) molar ratio of 1.02, and uniformly mixed;
S2, the mixed material was reacted for 20 hours at 900 °C under an air or oxygen condition, and the sintered block material from the reaction was crushed by mechanical mill or jet mill to obtain a single crystal material with a D50 particle size of 3.5 µm;
S3, the cathode material, a coating material, and a dispersant were dry mixed in a mixer, a metal oxide Al₂O₃ with a content of 0.1 wt% was used as the coating material, and graphite was used as the dispersant, the ratio of the dispersant to the coating material was 1:500, under the action of the blade shearing force, the interface between the cathode material and the coating material achieved a fusion effect;
S4, the coated cathode material was calcined at 700 °C for 10 hours, and the dispersant and the coating material were uniformly coated on the surface of the particles; and
S5. finally, the material was subjected to airflow classification with a classification frequency of 108 Hz and 325 mesh sieved to remove powders below 0.1 µm and greater than 15 µm, obtaining the final product, i.e. a single crystal material with a D50 particle size of 3.5 µm and a chemical expression of LiNi_{0.65}Mn_{0.35}O₂.

### Example 2

A composite cobalt-free cathode material provided in this Example is obtained by the following preparation method:
S1. lithium hydroxide and a precursor Ni_{0.35}Mn_{0.65}(OH)₂ with a D50 particle size of 2 µm were weighed at a Li/(Ni+Mn) molar ratio of 0.98, and uniformly mixed;
S2, the mixed material was reacted for 18 hours at 850 °C under an air or oxygen condition, and the sintered block material from the reaction was crushed by mechanical mill or jet mill;
S3, the cathode material, a coating material, and a dispersant were dry mixed in a mixer, a metal oxide TiO₂ with a content of 0.1 wt% was used as the coating material, and graphite was used as the dispersant, the ratio of the dispersant to the coating material was (1:400), under the action of the blade shearing force, the interface between the cathode material and the coating material achieved a fusion effect;
S4, the coated cathode material was calcined at 650 °C for 10 hours, and the dispersant and the coating material were uniformly coated on the surface of the particles; and
S5. finally, the material was subjected to airflow classification with a classification frequency of 120Hz and 350 mesh sieved to remove powders below 0.1 µm and greater than 15 µm, obtaining the final product, i.e. a single crystal material with a D50 particle size of 2.5 µm and a chemical expression of LiNi_{0.35}Mn_{0.65}O₂.

### Example 3

A composite cobalt-free cathode material provided in this Example is obtained by the following preparation method:
S1. lithium hydroxide and a precursor Ni_{0.65}Mn_{0.35}(OH)₂ with a D50 particle size of 4 µm weighed at a Li/(Ni+Mn) molar ratio of 1.04, and uniformly mixed;
S2, the mixed material was reacted for 23 hours at 850 °C under an air or oxygen condition, and the sintered block material from the reaction was crushed by mechanical mill or jet mill;
S3, the cathode material, a coating material, and a dispersant were dry mixed in a mixer, a metal oxide MgO with a content of 0.3 wt% was used as the coating material, and graphite was used as the dispersant, the ratio of the dispersant to the coating material was 1:400, under the action of the blade shearing force, the interface between the cathode material and the coating material achieved a fusion effect;
S4, the coated cathode material was calcined at 800 °C for 8 hours, and the dispersant and the coating material were uniformly coated on the surface of the particles; and
S5. finally, the material was subjected to airflow classification with a classification frequency of 108 Hz and 300 mesh sieved to remove powders below 0.1 µm and greater than 15 µm, obtaining the final product, i.e. a single crystal material with a D50 particle size of 4 µm and a chemical expression of LiNi_{0.35}Mn_{0.65}O₂.

### Comparative Example

An uncoated cobalt-free cathode material LiNi_{0.65}Mn_{0.35}O₂, i.e. a single crystal material with a D50 particle size of 3.5 µm, was used as a comparative example.

The performance comparisons between the products obtained in the above examples and the uncoated products are shown in the following table:

| | 0.5C, 50cls cycle capacity retention rate% | Discharge capacity 0.5C/0.1C | Discharge capacity 1C/0.1C | Discharge capacity 2C/0.1C | Discharge capacity 3C/0.1C |
|---|---|---|---|---|---|
| Comparative Example | 96.8 | 0.93 | 0.85 | 0.76 | 0.71 |
| Example 1 | 98.8 | 0.95 | 0.89 | 0.82 | 0.77 |
| Example 2 | 99.1 | 0.96 | 0.91 | 0.83 | 0.78 |
| Example 3 | 99.0 | 0.96 | 0.90 | 0.83 | 0.79 |

It can be seen from the above table that in the comparative example, 0.5C, 50cls cycle capacity is 96.8%, 0.5C/0.1C discharge capacity is 0.93, 1C/0.1C discharge capacity is 0.85, 2C/0.1C discharge capacity is 0.76, 3C/0.1C discharge capacity is 0.71; while in the composite cobalt-free cathode material obtained by the preparation method of the present disclosure, i.e. Example 1, Example 2, Example 3, 0.5C, 50cls average cycle capacity is 99.0%, 0.5C/0.1C average discharge capacity is 0.96, 1C/0.1C average discharge capacity of is 0.90, 2C/0.1C average discharge capacity is 0.83, and 3C/0.1C average discharge capacity is 0.78. It can be seen that the composite cobalt-free cathode material product obtained by adopting the preparation method of the cobalt-free cathode material provided in the present disclosure is superior to the uncoated cobalt-free cathode material in the comparative example in terms of the cycle capacity retention rate and the discharge capacity.

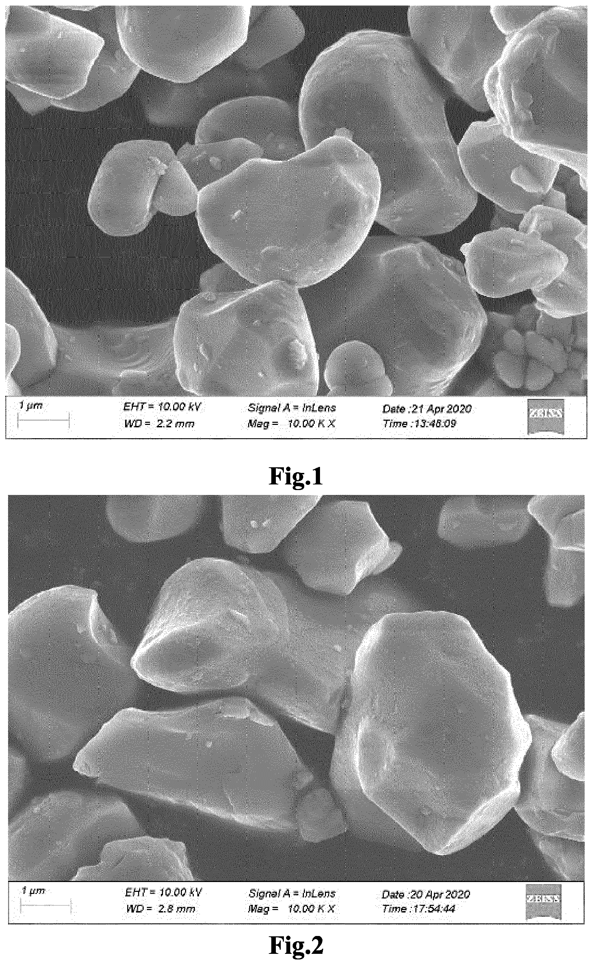

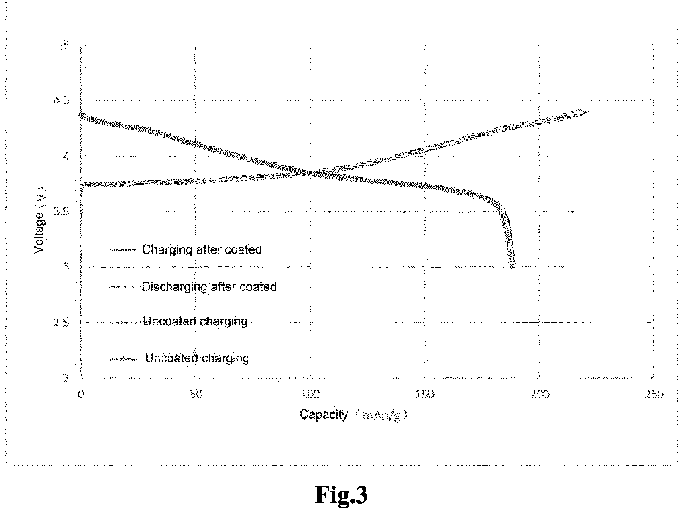

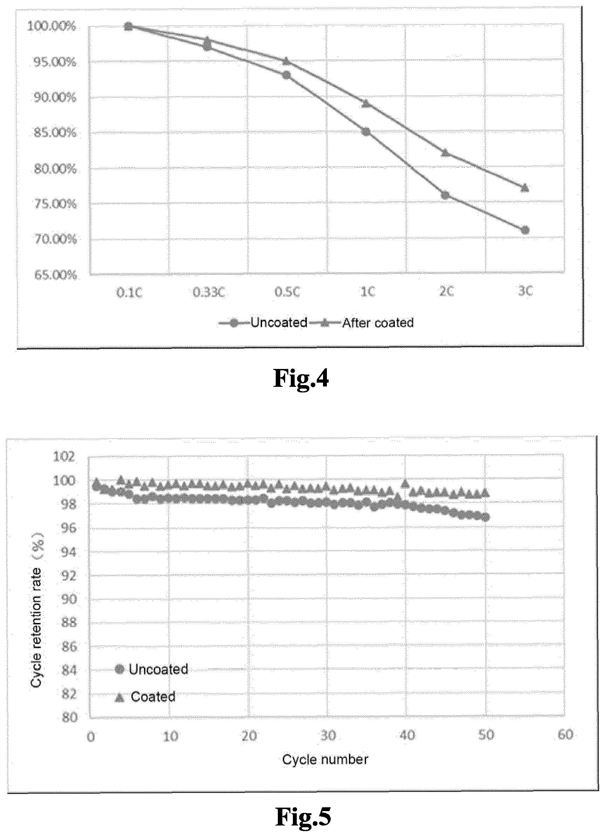

At the same time, it can be seen from the comparison between Figure 1 and Figure 2 that the uniformity of the particles on the surface of the product obtained in Example 1 is significantly better, therefore the surface stability of the product is higher. From Figures 2, 3, and 4, it can be seen that there is little difference between the charge and discharge performances of the product of Example 1 and the comparative product, but the rate performance and cycle retention rate of the product of Example 1 are significantly better than those of the comparative product.

In summary, in the present disclosure, a metal oxide is used as the coating material, and a dispersant with better fluidity is added to the coating material for co-coating, which effectively improves the surface stability of the cobalt-free single crystal material, and reduces the problem of gas production during the cycle of the battery, thereby improving the cycle life of the battery and increasing the rate performance at the same time.

## Claims

1. A composite cobalt-free cathode material, comprising a cobalt-free cathode material and further a composite coating layer, wherein the composite coating layer is formed by uniformly wrapping the surface of the cobalt-free cathode material with a coating material and a dispersant.

2. The composite cobalt-free cathode material according to claim 1, wherein the cobalt-free cathode material is a cobalt-free single crystal cathode material with a chemical expression of LiNiₓMn_{y}O₂, 0.3≤x≤1.0, x+y= 1, and a D50 particle size of 1 to 5 µm.

3. The composite cobalt-free cathode material according to claim 1, wherein the coating material comprises at least one of Al₂O₃, TiO₂, ZrO₂, MgO, B₂O₃ and WO₃, and the dispersant comprises at least one of graphite, polyethylene, polyvinylpyrrolidone, polyvinyl alcohol, polyethylene glycol and phenolic resin.

4. The composite cobalt-free cathode material according to claim 1, wherein the mass percentage content of the coating material is 0.1% to 3% of the mass of the cobalt-free cathode material, and the ratio of the dispersant to the coating material is (1:1000) to (1:10).

5. A preparation method of the composite cobalt-free cathode material according to any one of claims 1 to 4, comprising:
(1) a cobalt-free single crystal cathode material is prepared;
(2) the cobalt-free single crystal cathode material, a coating material, and a dispersant are dry mixed to obtain a mixture; and
(3) the mixture is calcined at 200 to 800 °C for 4 to 10 hours to obtain a composite cobalt-free cathode material product.

6. The preparation method of the composite cobalt-free cathode material according to claim 5, wherein it specifically comprises:
S1, a lithium source and a precursor NiₓMn₁₋ₓ(OH)₂ are weighed, and uniformly mixed;
S2, the mixed material is sintered, and the block material after the sintering reaction is crushed to obtain a cobalt-free single crystal cathode material;
S3, the cobalt-free single crystal cathode material, a coating material, and a dispersant are dry mixed in a mixer, a metal oxide is used as the coating material, the mass percentage content of which is 0.1% to 3% of the mass of the cobalt-free single crystal cathode material, and the ratio of the dispersant to the coating material is (1:1000) to (1:10);
S4, the coated cathode material is calcined at 200 to 800 °C for 4 to 10 hours, and the coating material and the dispersant are uniformly coated on the surface of the particles; and
S5, the calcined material is subjected to airflow classification and sieved to obtain the final product.

7. The preparation method of the composite cobalt-free cathode material according to claim 6, wherein in the step S1, the D50 particle size of the precursor is 1 to 4 µm, and the lithium source and the precursor are weighed at a Li/(Ni+Mn) molar ratio of 0.95 to 1.10.

8. The preparation method of the composite cobalt-free cathode material according to claim 6, wherein in the step S2, the temperature of the sintering reaction is 500 to 1000 °C, and the reaction is carried out under an air or oxygen condition for 10 to 25 hours.

9. The preparation method of the composite cobalt-free cathode material according to claim 6, wherein in the step S2, mechanical mill or jet mill is used for crushing, and the obtained cobalt-free single crystal cathode material has a D50 particle size of 1 to 5 µm.

10. The preparation method of the composite cobalt-free cathode material according to claim 6, wherein in the step S5, the airflow classification frequency is 100 to 200 Hz, and a sieve with a mesh size of 300 to 400 mesh is used for sieving.
